Europäisches Patentamt

European Patent Office

Office européen des brevets

(19)

(11) Veröffentlichungsnummer: **0 202 539**

**A1**

(12) # EUROPÄISCHE PATENTANMELDUNG

(21) Anmeldenummer: 86106219.8

(22) Anmeldetag: 06.05.86

(51) Int. Cl.⁴: **H01F 27/02** , H01F 27/06 , H05K 7/14 , H01R 25/14

(30) Priorität: 08.05.85 DE 3516446

(43) Veröffentlichungstag der Anmeldung:
26.11.86 Patentblatt 86/48

(84) Benannte Vertragsstaaten:
AT BE CH DE FR GB IT LI LU NL SE

(71) Anmelder: **Hailo-Werk Rudolf Loh GmbH & Co. KG**

**D-6342 Haiger(DE)**

(72) Erfinder: **Müller, Jürgen**
**Heidfeldstrasse 29**
**D-6344 Dietzhölztal 1(DE)**
Erfinder: **Klingberg, Herbert**
**Bergmannsweg 4**
**D-6342 Haiger 3(DE)**

(74) Vertreter: **Vogel, Georg**
**Hermann-Essig-Strasse 35**
**D-7141 Schwieberdingen(DE)**

(54) **Sicherheitstransformator.**

(57) Die Erfindung betrifft einen Sicherheitstransformator mit einem in einem Gehäuse (10) untergebrachten Niederspannungstransformator, der an eine Niederspannungs-Stromschiene (44) anschaltbar ist. Durch eine besondere Ausgestaltung des zusammensetzbaren Gehäuses mit einem Anschlußkontakte (21) und Verriegelungselemente (23) aufweisenden Steckteil (20) wird zusammen mit einer mit der Niederspannungs-Stromschiene koppelbaren Trägerplatte (38) eine eindeutige elektrische und mechanische Verbindung des Sicherheitstransformators an der Niederspannungs-Stromschiene erreicht. Außerdem kann der Sicherheitstransformator formgerecht in ein Niederspannungs-Beleuchtungssystem integriert werden.

Rank Xerox

Sicherheitstransformator

Die Erfindung betrifft einen Sicherheitstransformator mit einem in einem Gehäuse untergebrachten Niederspannungstransformator, der an eine Niederspannungs-Stromschiene anschaltbar ist.

Es sind Beleuchtungssysteme bekannt, bei denen von einem Sicherheitstransformator eine Kleinspannung auf eine Niederspannungs-Stromschiene eingespeist wird, an die Niederspannungsleuchten ansteckbar sind. Dieses Niederspannungs-Beleuchtungssystem hat den Vorteil, daß es ungefährlich ist, insbesondere im Bereich der Niederspannungs-Stromschiene und der daran angeschalteten Geräte. Der Sicherheitstransformator ist jedoch voluminös, so daß in der Regel seine Unterbringung oder Integration in das Niederspannungs-Beleuchtungssystem, d.h. seine Anschaltung an die Niederspannungs-Stromschiene, erhebliche Schwierigkeiten mit sich bringt. Es sei nur an die Anbringung eines derartigen Niederspannungs-Beleuchtungssystems an die Unterseite von Hängeschränken hingewiesen.

Es ist Aufgabe der Erfindung, einen Sicherheitstransformator der eingangs erwähnten Art zu - schaffen, der auf einfache Art und schnell elektrisch und mechanisch sicher an einer Niederspannungs-Stromschiene festgelegt werden kann und sich dabei formgerecht in das Niederspannungs-Beleuchtungssystem integrieren läßt.

Diese Aufgabe wird nach der Erfindung dadurch gelöst, daß als Niederspannungstransformator ein Ringkerntransformator in ein boxartiges, mittels einer Deckplatte verschließbares Gehäuseunterteil eingesetzt ist, daß das Gehäuse an einer Seite als Steckteil mit zwei vorstehenden Anschlußkontakten für die Niederspannung ausgebildet ist, daß im Steckteil beidseitig der Anschlußkontakte jeweils ein Verriegelungselement drehbar gelagert ist, mit dem das Gehäuse mechanisch an der Niederspannungs-Stromschiene festlegbar ist, daß das Gehäuse mit einer Trägerplatte verbindbar ist, die an den zur Befestigung dienenden Seitenschenkel der Niederspannungs-Stromschiene ankoppelbar und mit der Befestigungsfläche verbindbar ist, daß das Gehäuse senkrecht zur Trägerplatte auf diese aufsteckbar und durch Einführen des Steckteils in die Steckaufnahme der Niederspannungs-Stromschiene senkrecht zur Steckrichtung unlösbar daran festlegbar ist, und daß die Trägerplatte mit dem Gehäuse senkrecht zur Befestigungsfläche eine Bauhöhe aufweist, die etwa der Bauhöhe der Niederspannungs-Stromschiene in dieser Richtung entspricht.

Die Verwendung eines Ringkerntransformators läßt die Unterbringung in dem boxartigen Gehäuse mit extrem kleiner Bauhöhe von z.B. 21 mm zu. Die Anpassung der Bauhöhe an die Bauhöhe der Niederspannungs-Stromschiene bringt keine Raumprobleme, auch wenn der Sicherheitstransformator in eine an der Unterseite eines Hängeschrankes befestigte Niederspannungs-Stromschiene eingesteckt und daran festgelegt wird. Zudem läßt sich damit ein formschöner Übergang von dem Gehäuse des Sicherheitstransformators zu der Niederspannungs-Stromschiene erreichen. Die Trägerplatte trägt dazu bei, daß der Sicherheitstransformator über seine ganze Fläche getragen wird. Die Niederspannungs-Stromschiene ·mit der· Kontaktgabe und der Verriegelung wird dabei entlastet, da die Trägerplatte getrennt davon an der Befestigungsfläche angebracht werden kann, durch die Kopplung mit der Niederspannungs-Stromschiene aber die richtige Stellung dazu einhält.

Um eine möglichst optimale Raumausnutzung bei dem Sicherheitstransformator zu erreichen, sieht eine Ausgestaltung vor, daß das Gehäuseunterteil, die Deckplatte und die Trägerplatte etwa quadratischen Querschnitt aufweisen.

Ist nach einer weiteren Ausgestaltung vorgesehen, daß in den Eckbereichen der dem Steckteil gegenüberliegenden Seitenwand des Gehäuseteiles ein Sicherungshalter und eine Steckdose zur Zuführung der Netzwechselspannung angeordnet sind, dann wird dafür ein toter Raum im Gehäuse sinnvoll ausgenützt. Das mit einem einfachen Stecker versehene Anschlußkabel kann an der Steckdose angesteckt werden, um den Sicherheitstransformator mit Strom zu versorgen.

Eine ausreichende Leistung des Ringkerntransformators ohne Vergrößerung der Bauhöhe durch dessen Sekundärwicklung erreicht eine Ausgestaltung dadurch, daß die Sekundärwicklung des Ringkerntransformators aus mehreren parallel geschalteten Drähten gewickelt ist, die in den Windungen nebeneinander liegen.

Die mechanische Verriegelung des Gehäuses an der Niederspannungs-Stromschiene erreicht eine Ausgestaltung dadurch, daß die Verriegelungselemente aus einer rechteckförmigen Verriegelungsplatte und einer über einen Lagerbolzen damit verbundenen Handhabe bestehen, daß die Lagerbolzen in Lagerschalen des aus Teilen des Gehäuseunterteiles und der Deckplatte zusammengesetzten Steckteiles drehbar gelagert sind, wobei die Verriegelungsplatten außerhalb des Gehäuses liegen, die Handhaben in Aussparungen des Gehäuseunterteils und der Deckplatte begrenzt verdrehbar und die Drehachsen parallel zur Steckrichtung ausgerichtet sind.

Eine einfache Festlegung des Gehäuses an der Trägerplatte ergibt sich dadurch, daß auf den Innenseiten der zur Steckrichtung parallelen Seitenwände des Gehäuseunterteils im Abstand zueinander stehende Leisten angeformt sind, daß die Deckplatte eine Breite aufweist, die den lichten Abstand der beiden Seitenwände im Bereich dieser Leisten entspricht, daß die Deckplatte bündig in das Gehäuseunterteil einsetzbar ist und entlang der parallel zur Steckrichtung gerichteten Oberkanten Absätze aufweist, daß die Trägerplatte eine Breite aufweist, die dem lichten Abstand der beiden Seitenwände im Bereich der Leisten entspricht und daß an den parallel zur Steckrichtung verlaufenden Rändern der Trägerplatte Haltelaschen angeformt sind, die zwischen den Leisten des Gehäuseunterteils senkrecht dazu in das Gehäuseunterteil einführbar und durch Verschieben in Steckrichtung hinter diesen Leisten verriegelbar sind. Damit in der Überdeckung von Gehäuse und Trägerplatte die Festlegung senkrecht zur Steckrichtung erreicht wird, sieht eine Ausgestaltung vor, daß die Haltelaschen an der Trägerplatte in gleicher Verteilung angebracht sind wie die Leisten an den Innenseiten der Seitenwände des Gehäuseunterteils, in Steckrichtung aber eine kleinere Abmessung aufweisen als die Leisten. In der Festlegungsstellung überdeckt dann das Gehäuse die Trägerplatte vollständig und es ist nach dem Aufstecken des Gehäuses auf die Trägerplatte - was senkrecht zur Trägerplatte geschieht -nur ein kleiner Verstellweg des Gehäuses in Steckrichtung erforderlich. Diese Verstellbewegung muß sowieso ausgeführt werden, um das Steckteil des Gehäuses mit den Anschlußkontakten und den Verriegelungselementen in die Steckaufnahme der Niederspannungs-Stromschiene einzuführen.

Damit die Aufsteckbewegung des Gehäuses auf die Trägerplatte nicht behindert wird und sich die Trägerplatte unmittelbar an die Deckplatte des Gehäuses anschließen kann, sieht eine Ausgestaltung vor, daß die Absätze an der Deckplatte eine Tiefe aufweisen, die der maximalen Dicke der Trägerplatte im Bereich der angeformten Haltelaschen entspricht, daß die Haltelaschen um die Dicke der Leisten gegenüber der Befestigungsseite der Trägerplatte abgesetzt sind, daß die Breite der Trägerplatte im Bereich der Haltelaschen dem maximalen lichten Abstand der Seitenwände des Gehäuseunterteils zwischen den Leisten entspricht, und daß die Leisten bündig mit den Oberkanten der Seitenwände abschließen.

Eine Begrenzung der Verstellbewegung des Gehäuses auf der Trägerplatte in Steckrichtung ergibt sich nach einer Ausgestaltung einfach dadurch, daß die Leisten an den dem Steckteil abgekehrten Enden über einen Absatz in dickere Abschnitte übergehen.

Um die Trägerplatte möglichst dünn auslegen zu können, die Haltelaschen aber dennoch ausreichend fest mit der Trägerplatte verbinden zu können, sieht eine Ausgestaltung vor, daß die Absätze an den parallel zur Steckrichtung verlaufenden Rändern der Trägerplatte eine Breite aufweisen, die durch die halbe Differenz aus dem lichten Abstand der Leisten des Gehäuseunterteiles und dem lichten Abstand der Innenkanten der an der Trägerplatte abstehend angeformten Haltelaschen gegeben ist.

Für die einfachste Anbringung der Trägerplatte an der Befestigungsfläche ist vorgesehen, daß die Trägerplatte mit Befestigungsbohrungen versehen ist.

Die Kopplung zwischen der Trägerplatte und der Niederspannungs-Stromschiene ist nach einer Ausgestaltung so ausgeführt, daß der Seitenschenkel zur Befestigung der Niederspannungs-Stromschiene stirnseitig in einen, gegenüber der Außenseite desselben zurückgesetzten Haltesteg ausläuft und daß die Trägerplatte an der zugekehrten Seite mit Steckaufnahmen zur Aufnahme dieses Haltesteges versehen ist, die vorzugsweise mittels zweier im Abstand zueinander angeordneter, an der Trägerplatte angeformter Laschen gebildet sind.

Die Verbindung zwischen dem Gehäuseunterteil und der Deckplatte ist nach einer Ausgestaltung so vorgenommen, daß das Gehäuseunterteil und die Deckplatte zentrische, fluchtende Bohrungen für eine Befestigungsschraube aufweisen, wobei gleichzeitig auch der Ringkerntransformator in dem zusammengesetzten Gehäuse festgelegt werden kann.

Die Erfindung wird anhand eines in der Zeichnung dargestellten Ausführungsbeispieles näher erläutert. Es zeigt jeweils in perspektivischer Ansicht:

Fig. 1 das Gehäuseunterteil mit dem eingesetzten Ringkerntransformator,

Fig. 2 die Deckplatte für das Gehäuseunterteil nach Fig. 1,

Fig. 3 die mit der Niederspannungs-Stromschiene koppelbare Trägerplatte und

Fig. 4 einen Abschnitt der Niederspannungs-Stromschiene.

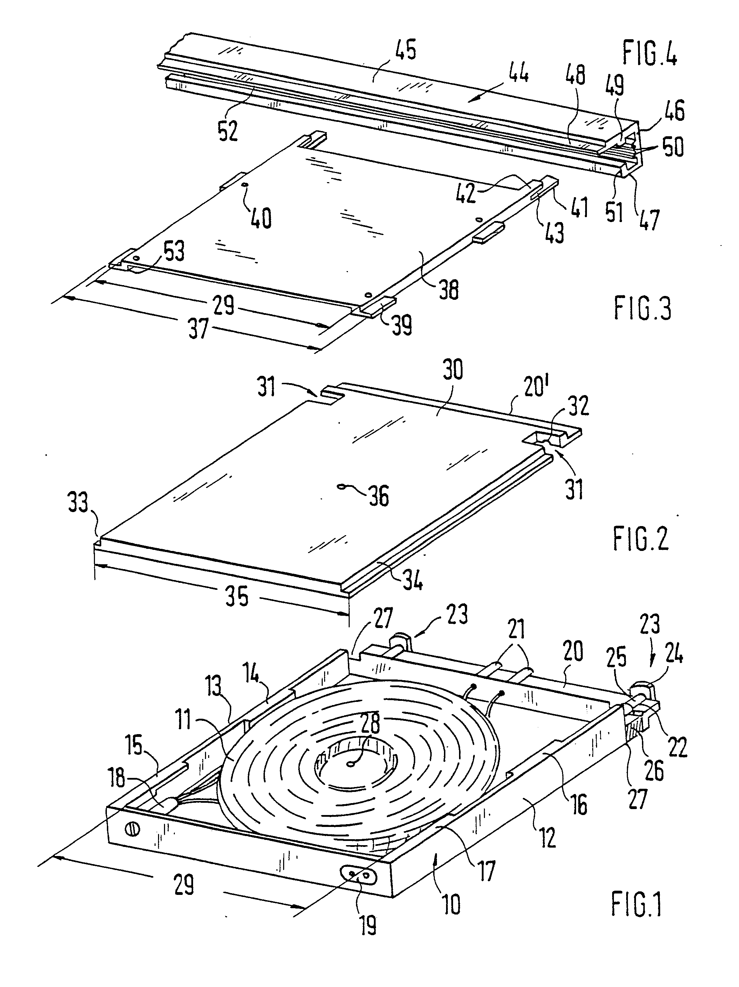

Das im Querschnitt etwa quadratische Gehäuseunterteil 10 ist boxartig ausgebildet, wie Fig. 1 zeigt, und nimmt den Ringkerntransformator 11 als Niederspannungstransformator auf. Damit die Bauhöhe des Ringkerntransformators auch bei größerer Leistung für mehrere Niederspannungsverbraucher klein bleibt, wird die Sekundärwicklung aus mehreren parallelgeschalteten Drähten gewickelt, die in den Windungen nebeneinander liegen, um den erforderlichen Drahtquerschnitt ohne Erhöhung der Bauhöhe zu bekommen.

Die vordere Seite des Gehäuseunterteils 10 ist als Steckteil 20 ausgebildet, in dem übereinander zwei U-förmige Anschlußkontakte 21 so gelagert sind, daß die Enden ihrer Seitenschenkel am Steckteil 20 vorstehen. Der Abstand der beiden Anschlußkontakte 21 (von denen in Fig. 1 nur der obere sichtbar ist), richtet sich nach dem Abstand der Kontaktschienen 50 auf der Innenseite des Mittelschenkels 46 der Niederspannungs-Stromschiene 44 nach Fig. 4.

Wird die Deckplatte 30 mit dem Gehäuseunterteil 10 verbunden, dann wird eine Befestigungsschraube durch die mittigen, fluchtenden Bohrungen 28 und 36 geführt. Der Teil 20' der Deckplatte 30 vervollständigt das STeckteil und die Verriegelungselemente 23, die aus der rechteckigen Verriegelungsplatte 24 und der Handhabe 26, sowie dem Lagerbolzen 25 bestehen, sind darin drehbar gelagert. Der Lagerbolzen 25 verbindet die Verriegelungsplatte 24 mit der Handhabe 26 und ist in der halbkreisförmigen Lagerschale 22 des Steckteiles 20 und den halbkreisförmigen Lagerschalen 32 der Deckplatte 30 gelagert, wobei die Drehachsen parallel zur Steckrichtung ausgerichtet sind.

Sind die Verriegelungsplatten 24 mit ihren größeren Abmessungen in Längsrichtung der Niederspannungs-Stromschiene 44 ausgerichtet, dann können sie in die Steckaufnahme 52 der Niederspannungs-Stromschiene 44 eingeführt werden. Werden die Verriegelungsplatten 24 mit Hilfe der Handhaben 26 um 90° verdreht, dann legen sich die Verriegelungsplatten 24 hinter die an den Innenseiten der Seitenschenkel 45 und 47 angeformten Haltesteg 49 und 51, so daß das Gehäuse mechanisch an der Niederspannungs-Stromschiene 44 festgelegt ist. Die Niederspannungs-Stromschiene 44 wird mit dem Seitenschenkel 45, der den Seitenschenkel 47 überragt mit der Befestigungsfläche verbunden, so daß die Steckrichtung parallel dazu verläuft.

In den Eckbereichen der dem Steckteil 20 gegenüberliegenden Seitenwand des Gehäuseunterteils 10 sind der Sicherungshalter 18 und die Steckdose 19 angeordnet. Ein mit Stecker versehenes Anschlußkabel wird an der Steckdose 19 angesteckt und führt dem Sicherheitstransformator die Netzwechselspannung zu.

Auf den Innenseiten der Seitenwände 12 und 13, die parallel zur Steckrichtung verlaufen, sind bündig mit deren Oberkanten die Leisten 14 und 15 bzw. 16 und 17 angeformt, die jeweils im Abstand zueinander angeordnet sind. Im Bereich der Leisten 14 und 16 bzw. 15 und 17 haben die Seitenwände 12 und 13 nur den lichten Abstand 29, der der maximalen Breite 35 der Deckplatte 30 entspricht. Die parallel zur Steckrichtung verlaufenden Ränder der Deckplatte 38 haben an der Oberseite Absätze 33 und 34. Die Leisten 14 bis 17 sind auf den Innenseiten in der Dicke abgestuft und bilden Anschläge. Die Dicke der Leisten 14 bis 17 an den dünnen Stellen entspricht etwa der Dicke der seitlich an der Trägerplatte 38 angeformten Haltelaschen 39 und der halben Tiefe der Absätze 33 und 34 an der Deckplatte 30.

Ist die Deckplatte 30 bündig in das Gehäuseunterteil 10 eingesetzt, dann verbleiben zwischen den Seitenwänden 12 und 13, den Leisten 14 bis 17 und der Deckplatte 30 Schlitze, in die von oben her die Haltelaschen 39 eingeführt und dann hinter die dünnen Abschnitte der Leisten 14 bis 17 verschoben werden können. Da die Leisten 14 bis 17 und die Haltelaschen 39 in gleicher Verteilung angebracht sind, überdeckt das Gehäuse in dieser Stellung dann die Trägerplatte 38 vollständig.

Die maximale Breite 37 der Trägerplatte 38 im Bereich der Haltelaschen 39 entspricht der maximalen lichten Weite der Seitenwände 12 und 13 zwischen den Leisten 14 bis 17, während die übrige Breite 29 der Trägerplatte 38 dem lichten Abstand 29 der Seitenwände 12 und 13 im Bereich der Leisten 14 und 16 bzw. 15 und 17 entspricht. Die Haltelaschen 39 sind von der Befestigungsseite der Trägerplatte 38 um die Dicke der Leisten 14 bis 17 an den dünneren Abschnitten zurückgesetzt, damit beim Aufliegen der Trägerplatte 38 auf der Oberseite der Deckplatte 30 die Haltelaschen 39 hinter die Leisten 14 bis 17 geschoben werden können. Die Haltelaschen 39 sind an der dünnen Trägerplatte 38 so angeformt, daß sich auf deren Unterseite die Innenkanten 53 bilden. Die Breite der Absätze 33 und 34 an der Deckplatte 30 ist nun so gewählt, daß die Deckplatte 30 in dem Bereich mit der gesamten Dicke eine Breite aufweist, die dem lichten Abstand der Innenkanten 53 der Haltelaschen 39 entspricht. Auf diese Weise können bei dem in das Gehäuseunterteil 10 eingesetzten Deckel 30 die Haltelaschen 39 über die Absätze 33 und 34 in die verbleibenden Schlitze zwischen den Leisten 14 bis 17, den Seitenwänden 12 und 13, sowie den Rändern der Deckplatte 30 eingeführt werden, wobei sich die Trägerplatte 38 satt an die Oberseite der Deckplatte 30 anschließt.

An der der Niederspannungs-Stromschiene 44 zugekehrten Seite der Trennplatte 38 sind Paare von Laschen 41 und 42 angeformt, die Steckaufnahmen 43 für den an dem freien Ende des Seitenschenkels 45 angebrachten Haltesteg 48 bilden. Dieser Haltesteg 48 ist gegenüber der Außenseite, d.h. Befestigungsfläche, des Seitenschenkels 45 zurückgesetzt, so daß die Kopplung zwischen der Niederspannungs-Stromschiene 44 und der Trägerplatte 38 so hergestellt werden kann, daß die Außenseite des Seitenschenkels 45 und die Befestigungsseite der Trägerplatte 38 bündig ineinander übergehen. Mittels der Befestigungsbohrungen 40 wird die Trägerplatte 38 dann getrennt von der Niederspannungs-Stromschiene 44, aber in definierter Zuordnung zu dieser an der Befestigungsfläche angeschraubt. In dieser Zuordnung wird das Gehäuse senkrecht zu der Befestigungsfläche auf die Trägerplatte 38 aufgesteckt, wobei die Haltelaschen 39 in die verbleibenden Schlitze zwischen den Leisten 14 bis 17 eingeführt werden. Beim Verstellen des Gehäuses in Richtung der Niederspannungs-Stromschiene 44 werden die Haltelaschen 39 hinter die Leisten 14 bis 17 verschoben und das Steckteil 20,20' in die Steckaufnahme 52 der Niederspannungs-Stromschiene 44 eingeführt. Die Anschlußkontakte 21 stellen die elektrischen Verbindungen her und mit den Verriegelungselementen 23 wird das Gehäuse mechanisch an der Niederspannungs-Stromschiene 44 festgelegt.

**Ansprüche**

1. Sicherheitstransformator mit einem in einem Gehäuse untergebrachten Niederspannungstransformator, der an eine Niederspannungs-Stromschiene anschaltbar ist,

dadurch gekennzeichnet,

daß als Niederspannungstransformator ein Ringkerntransformator (11) in ein boxartiges, mittels einer Deckplatte (30) verschließbares Gehäuseunterteil (10) eingesetzt ist,

daß das Gehäuse an einer Seite als Steckteil - (20,20') mit zwei vorstehenden Anschlußkontakten - (21) für die Niederspannung ausgebildet ist,

daß im Steckteil (20,20') beidseitig der Anschlußkontakte (21) jeweils ein Verriegelungselement (23) drehbar gelagert ist, mit dem das Gehäuse mechanisch an der Niederspannungs-Stromschiene (44) festlegbar ist,

daß das Gehäuse mit einer Trägerplatte (38) verbindbar ist, die an den zur Befestigung dienenden Seitenschenkel (45) der Niederspannungs-Stromschiene (44) ankoppelbar und mit der Befestigungsfläche verbindbar ist,

daß das Gehäuse senkrecht zur Trägerplatte (38) auf diese aufsteckbar und durch Einführen des Steckteils (20,20') in die Steckaufnahme (52) der Niederspannungs-Stromschiene (44) senkrecht zur Steckrichtung unlösbar daran festlegbar ist, und

daß die Trägerplatte (38) mit dem Gehäuse senkrecht zur Befestigungsfläche eine Bauhöhe aufweist, die etwa der Bauhöhe der Niederspannungs-Stromschiene (44) in dieser Richtung entspricht.

2. Sicherheitstransformator nach Anspruch 1,

dadurch gekennzeichnet,

daß das Gehäuseunterteil (10), die Deckplatte (30) und die Trägerplatte (38) etwa quadratischen Querschnitt aufweisen.

3. Sicherheitstransformator nach Anspruch 1 oder 2,

dadurch gekennzeichnet,

daß in den Eckbereichen der dem Steckteil - (20,20') gegenüberliegenden Seitenwand des Gehäuseunterteils (10) ein Sicherungshalter (18) und eine Steckdose (19) zur Zuführung der Netzwechselspannung angeordnet sind.

4. Sicherheitstransformator nach einem der Ansprüche 1 bis 3,

dadurch gekennzeichnet,

daß die Sekundärwicklung des Ringkerntransformators (11) aus mehreren parallel geschalteten Drähten gewickelt ist, die in den Windungen nebeneinander liegen.

5. Sicherheitstransformator nach einem der Ansprüche 1 bis 4,

dadurch gekennzeichnet,

daß die Verriegelungselemente (23) aus einer rechteckförmigen Verriegelungsplatte (24) und einer über einen Lagerbolzen (25) damit verbundenen Handhabe (26) bestehen, daß die Lagerbolzen (25) in Lagerschalen (22,32) des aus Teilen (20,20') des Gehäuseunterteiles (10) und der Deckplatte (30) zusammengesetzten Steckteiles drehbar gelagert sind, wobei die Verriegelungsplatten (24) außerhalb des Gehäuses liegen, die Handhaben (26) in Aussparungen (27,31) des Gehäuseunterteils (10) und der Deckplatte (30) begrenzt verdrehbar und die Drehachsen parallel zur Steckrichtung ausgerichtet sind.

6. Sicherheitstransformator nach einem der Ansprüche 1 bis 5,

dadurch gekennzeichnet,

daß auf den Innenseiten der zur Steckrichtung parallelen Seitenwände (12,13) des Gehäuseunterteils (10) im Abstand zueinander stehende Leisten (14,15 bzw. 16,17) angeformt sind,

daß die Deckplatte (30) eine Breite (35) aufweist, die den lichten Abstand (29) der beiden Seitenwände (12,13) im Bereich dieser Leisten (14 zu 16 bzw. 15 zu 17) entspricht,

daß die Deckplatte (30) bündig in das Gehäuseunterteil (10) einsetzbar ist und entlang der parallel zur Steckrichtung gerichteten Oberkanten Absätze (33,34) aufweist,

daß die Trägerplatte (38) eine Breite (29) aufweist, die dem lichten Abstand (29) der beiden Seitenwände (12,13) im Bereich der Leisten - (14,15,16,17) entspricht und

daß an den parallel zur Steckrichtung verlaufenden Rändern der Trägerplatte (38) Haltelaschen (39) angeformt sind, die zwischen den Leisten - (14,15,16,17) des Gehäuseunterteils (10) senkrecht dazu in das Gehäuseunterteil (10) einführbar und durch Verschieben in Steckrichtung hinter diesen Leisten (14,15,16,17) verriegelbar sind.

7. Sicherheitstransformator nach Anspruch 6,

dadurch gekennzeichnet,

daß die Haltelaschen (39) an der Trägerplatte (38) in gleicher Verteilung angebracht sind wie die Leisten (14,15,16,17) an den Innenseiten der Seitenwände (12,13) des Gehäuseunterteils (10), in Steckrichtung aber eine kleinere Abmessung aufweisen als die Leisten (14,15,16,17).

8. Sicherheitstransformator nach Anspruch 6 oder 7,

dadurch gekennzeichnet,

daß die Absätze (33,34) an der Deckplatte (30) eine Tiefe aufweisen, die der maximalen Dicke der Trägerplatte (38) im Bereich der angeformten Haltelaschen (39) entspricht,

daß die Haltelaschen (39) um die Dicke der Leisten (14,15,16,17) gegenüber der Befestigungsseite der Trägerplatte (38) abgesetzt sind,

daß die Breite der Trägerplatte (38) im Bereich der Haltelaschen (39) dem maximalen lichten Abstand der Seitenwände (12,13) des Gehäuseunterteils - (10) zwischen den Leisten (14,15,16,17) entspricht, und

daß die Leisten (14,15,16,17) bündig mit den Oberkanten der Seitenwände (12,13) abschließen.

9. Sicherheitstransformator nach einem der Ansprüche 6 bis 8,

dadurch gekennzeichnet,

daß die Leisten (14 bis 17) an den dem Steckteil - (20,20') abgekehrten Enden über einen Absatz in dickere Abschnitte übergehen.

10. Sicherheitstransformator nach einem der Ansprüche 6 bis 9,

dadurch gekennzeichnet,

daß die Absätze (33,34) an den parallel zur Steckrichtung verlaufenden Rändern der Trägerplatte - (38) eine Breite aufweisen, die durch die halbe Differenz aus dem lichten Abstand der Leisten (14 bis 17) des Gehäuseunterteils (10) und dem lichten Abstand der Innenkanten (53) der an der Trägerplatte (38) abstehend angeformten Haltelaschen (39) gegeben ist.

11. Sicherheitstransformator nach einem der Ansprüche 1 bis 10,

dadurch gekennzeichnet,

daß die Trägerplatte (38) mit Befestigungsbohrungen (40) versehen ist.

12. Sicherheitstransformator nach einem der Ansprüche 1 bis 11,

dadurch gekennzeichnet,

daß der Seitenschenkel (45) zur Befestigung der Niederspannungs-Stromschiene (44) stirnseitig in einen, gegenüber der Außenseite desselben zurückgesetzten Haltesteg (48) ausläuft und

daß die Trägerplatte (38) an der zugekehrten Seite mit Steckaufnahmen (43) zur Aufnahme dieses Haltesteges (48) versehen ist, die vorzugsweise mittels zweier im Abstand zueinander angeordneter, an der Trägerplatte (38) angeformter Laschen (41,42) gebildet sind.

13. Sicherheitstransformator nach einem der Ansprüche 1 bis 12,

dadurch gekennzeichnet,

daß das Gehäuseunterteil (10) und die Deckplatte - (30) zentrische, fluchtende Bohrungen (28,36) für eine Befestigungsschraube aufweisen.

FIG.4

45

44

52

48

49

46

50

51

47

42

40

41

43

53

38

29

37

39

FIG.3

30

31

20'

32

31

36

33

FIG.2

34

35

27

23

21

20

23

25

24

13

14

11

15

28

22

18

26

27

12

16

17

10

29

19

FIG.1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| A | BBC NACHRICHTEN, Band 56, Heft 1/2, 1974, Seiten 12-16; R. LÜTTICH: "Peridat-Trennwandler - Eigenschaften und Anwendung" * Figur 6 * | 1,2 | H 01 F 27/02 H 01 F 27/06 H 05 K 7/14 H 01 R 25/14 |
| A | DE-B-1 240 963 (SIEMENS) * Spalte 3, Zeile 50 - Spalte 5, Zeile 51 * | 1,2 | |
| A | DE-A-3 415 899 (PROFILUX SRL) * Seite 9, Zeilen 19-21 * | 1,5 | |
| A | FR-A-2 538 120 (ENERTEC) | | |
| A | CH-A- 372 102 (MOSER-GLASER & CO.) | | RECHERCHIERTE SACHGEBIETE (Int. Cl.4) |
| A | US-A-3 751 574 (ADVANCE TRANSFORMER CO.) | | H 01 F 27/00 H 01 F 15/00 H 01 F 31/00 H 05 K 7/00 H 01 R 25/00 |
| P,A | DE-U-8 513 492 (HAILO-WERK R. LOH) | | |

Der vorliegende Recherchenbericht wurde für alle Patentansprüche erstellt.

| Recherchenort | Abschlußdatum der Recherche | Prüfer |
|---|---|---|
| DEN HAAG | 14-08-1986 | VANHULLE R. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument